# EUROPEAN PATENT APPLICATION

(11) **EP 4 766 049 A1**
(43) Date of publication of application: **24.06.2026**
(21) Application number: 24307221.2
(22) Date of filing: 20.12.2024
(51) Int. Cl.: H05K 7/20

(54) **PRIORITIZED LIQUID COOLING ARRANGEMENTS FOR DATACENTER SERVER RACKS**

(71) Applicant: OVH, 59100 Roubaix (FR)
(72) Inventor: CHEHADE, Ali, 59283 Moncheaux (FR); HNAYNO, Mohamad, 59110 La Madeleine (FR); KLABA, Miroslaw Piotr, 59100 Roubaix (FR); VAHIDI FERDOUSI, Mahdi, 59800 Lille (FR)
(74) Representative: BCF Global

(57) **Abstract**

A liquid cooling arrangement system for cooling a plurality of server clusters is disclosed. The plurality of server clusters each contain heat generating devices with liquid cooling units, comprising: a cooling circuit configured to circulate a cooling liquid and to circulate a heated liquid from the plurality of server clusters back to a dry cooler unit; the plurality of server clusters including: a first cluster and a second cluster connected in series by the cooling circuit, the first cluster including a first set of liquid cooling units connected in parallel by the cooling circuit, the first set having a first number of liquid cooling units, the second cluster including a second set of liquid cooling units connected in parallel by the cooling circuit, the second set having a second number of liquid cooling units, wherein the first number being above the second number.

## Description

### FIELD OF TECHNOLOGY

The present technology relates to datacenter server rack liquid cooling configurations.

### BACKGROUND

Datacenters are configured to house multitudes of server racks containing electronic equipment, such as computer systems (e.g., server assemblies), memory banks, etc. in efforts to process vast amounts of data in near real time. During operations, the electronic equipment of the server racks generates a significant amount of heat that must be dissipated in order to ensure continued efficient operation of the electronic equipment. Many cooling solutions have been implemented to address this heating issue, including the liquid cooling of heat-generating components by way of liquid cooling blocks directly mounted onto certain heat-generating components (often referred to as liquid or water block units).

Although water block units are capable of efficiently cooling the heat-generating components, their implementation in server racks typically requires a liquid distribution infrastructure to service the multitude of server racks and the vast number of electronic equipment supported therein. Moreover, certain server racks contain servers with high-performance electronic processing components that generate higher-generating temperature profiles as opposed to other servers containing electronic components that do not generate higher temperature profiles.

It will be appreciated that liquid cooling distribution infrastructures conventionally require the use of extensive piping conduit implementations that span across the data center as well as numerous pumps to maintain the necessary cooling liquid flow rates to supply the multitude of water blocks, especially for the high-performance electronic processing components. The use of extensive piping conduit implementations and numerous pumps can be prohibitively costly for datacenters, in terms of initial investments and operating costs.

As a result, it appears to be desirable to provide a liquid cooling arrangement for datacenter server racks that can alleviate at least some of the cost prohibitive issues regarding conventional piping conduit implementations and pumps by providing a configuration that effectively addresses the cooling needs of both, servers having processing assemblies generating higher temperature profiles due to electronic components and servers having processing assemblies generating standard temperature profiles.

It is to be noted that the subject matter discussed in the background section should not be assumed to be prior art merely as a result of its mention in the background section. Similarly, the issues mentioned in the background section should not be interpreted as having been recognized in the prior art.

### SUMMARY

It is an object of the present technology to alleviate at least some of the cost prohibitive issues regarding that prevail in the prior art.

According to one aspect of the present technology, there is provided a liquid cooling arrangement system for cooling a plurality of server clusters that each contain heat generating devices with liquid cooling units, comprising: a cooling circuit configured to circulate a cooling liquid to the plurality of server clusters and to circulate a heated liquid from the plurality of server clusters back to a dry cooler unit; the plurality of server clusters including: a first cluster and a second cluster connected in series by the cooling circuit, the first cluster including a first set of liquid cooling units connected in parallel by the cooling circuit, the first set having a first number of liquid cooling units, the second cluster including a second set of liquid cooling units connected in parallel by the cooling circuit, the second set having a second number of liquid cooling units, the second cluster positioned further downstream along the cooling circuit and configured to receive the cooling liquid egressing out of the first cluster, wherein the first number being above the second number.

Implementations of the present technology each have at least one of the above-mentioned objects and/or aspects, but may not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 depicts a functional block diagram of an internal server cluster configuration of a datacenter server rack, in accordance with the non-limiting embodiments of the present disclosure;
FIG. 2 depicts a functional block diagram of a liquid cooling system that optimizes cooling efficiency by prioritizing server clusters within a datacenter rack, in accordance with some non-limiting embodiments of the present disclosure;
FIG. 3 depicts a graph of operational upper casing temperatures of heat generating electronic processing components and cooling liquid temperature in accordance with some non-limiting embodiments of the present disclosure; and
FIG. 4 depicts a graph of flow rate versus pressure drop in accordance with some non-limiting embodiments of the present disclosure.

### DETAILED DESCRIPTION

The instant disclosure is directed to addressing at least some of the issues associated with the conventional use of various piping conduit configurations and numerous pumps to supply the liquid flows to the water blocks servicing the cooling needs of the multitude of heat-generating components. In particular, the instant disclosure presents embodiments of liquid cooling arrangements that prioritize higher heat generating servers to optimize the cooling thereof while streamlining liquid-cooling piping conduit arrangements.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate the implementations of the various inventive aspects of the present disclosure.

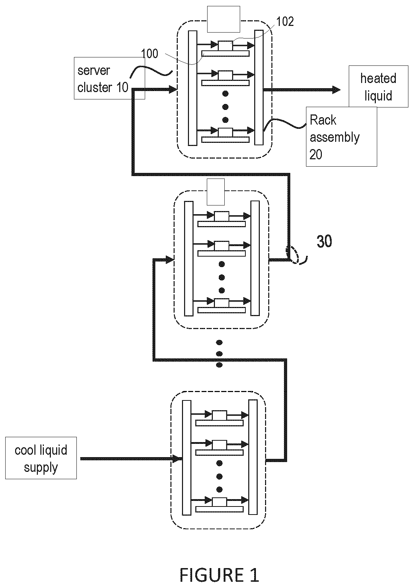

FIG. 1 depicts a functional block diagram of a representative plurality of internal server clusters (such as a server cluster 10) configuration of a plurality of datacenter server racks (such as a rack assembly 20), in accordance with the non-limiting embodiments of the present disclosure. Generally speaking, each server cluster contains heat generating electronic processing components.

In the context of the present application, term "heat-generating components" refers broadly to any electronic or mechanical devices, systems, or subassemblies that produce heat as a byproduct of their operation. These components may include, but are not limited to, central processing units (CPUs), graphics processing units (GPUs), application-specific integrated circuits (ASICs), memory modules (e.g., RAM), power supply units (PSUs), data storage devices (e.g., hard drives and solid-state drives), networking hardware (e.g., routers and switches), and other similar components commonly found in computing systems, server architectures, or industrial control systems. Heat may be generated due to electrical resistance, high processing loads, or rapid switching operations within these components. In some embodiments, heat-generating components could also include motors, actuators, or other electromechanical devices integrated into hybrid systems. The cooling system described herein is designed to dissipate this heat effectively, regardless of the specific type or configuration of the heat-generating components.

As shown, each of the data processing assemblies (such as the data processing assembly 100) incorporates at least one respective liquid cooling block unit (such as the block unit 102) disposed in direct thermal contact with the heat-generating electronic processing components. The block unit 102 is configured with internal conduits (*not shown*) to accommodate the circulated flow of channelized cooling liquid therethrough. The channelized cooling liquid is provided by a cooling liquid supply that is serially conveyed to each of the liquid cooling block units via an internal server cluster liquid circulating channel 30 to absorb the thermal energy from the heat-generating electronic components and discharge the heated liquid therefrom.

Although in the illustrated embodiment, each server cluster is associated with a respective rack assembly, it is not limited as such. It is contemplated that a plurality of server clusters is installed on a single rack assembly. Alternatively, it is also contemplated that the plurality of server clusters is installed across a plurality of server rack assemblies.

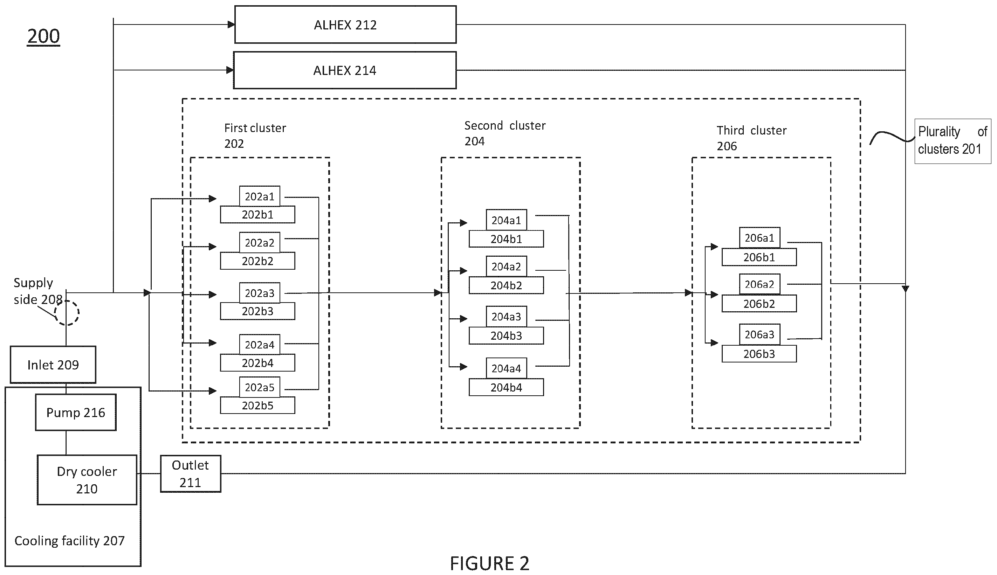

Given the internal datacenter server cluster 10 configuration described above, FIG. 2 depicts a functional block diagram of a liquid cooling arrangement 200 that optimizes overall cooling efficiency by prioritizing server clusters of a datacenter rack, in accordance with non-limiting embodiments of the present disclosure. While the embodiments and implementations described herein are directed to a datacenter rack, it will be appreciated that extending such concepts to encompass multiple datacenter racks are clearly within the scope of the present technology.

As shown, liquid cooling arrangement 200 comprises a single liquid distribution circuit 208 configured with a supply side to supply a cooling liquid to a plurality of server clusters 201, comprising the first server cluster 202, the second server cluster 204 and the third server cluster 206 from a cooling facility 207 and a return side to return a heated liquid from the plurality of server clusters 201 back to the cooling facility 207 for recooling and recirculation back to the plurality of server clusters 201. As noted above relative to FIG. 1, each of the first server cluster 202, the second server cluster 204 and the third server cluster 206 comprises data processing assemblies that incorporate at least one corresponding liquid cooling block unit for direct thermal contact with the heat generating electronic components of the data processing assemblies for dissipation of heat therefrom. Although in the illustrated embodiment, only three server clusters are shown, this is done for ease of illustration and it is contemplated that the liquid cooling arrangement 200 be implemented with two, or more than three server clusters.

The liquid distribution circuit 208 is configured with a liquid distribution inlet 209 along the supply side for supplying the cooling liquid to the fluidly-coupled plurality of server clusters 201, and a liquid distribution outlet 211 along the return side for receiving a heated liquid from the plurality of server clusters 201, and returning the heated liquid back to the cooling facility 207 for recooling and recirculation back to the plurality of server clusters 201. The liquid distribution circuit 208 may be constructed from flexible materials (e.g., rubber, plastic, *etc.*)*,* rigid materials (*e.g.,* metal, PVC piping, *etc.*)*,* or any combination of thereof. It will be appreciated that the conveyed liquid may include water, alcohol, or any suitable liquid capable of sustaining adequate cooling temperatures. It should be noted that the first server cluster 202, the second server cluster 204 and the third server cluster 206 are arranged in a serial manner (i.e. one after the other) via the liquid distribution circuit 208.

The cooling facility 207 may comprise a dry cooler unit 210 configured to process and recondition received liquids from the plurality of server clusters 201 to provide cooling liquid for recirculation back to the plurality of server clusters 201 via the liquid distribution circuit 208. The cooling facility 207 may further comprise a pump 216 configured to provide the necessary pressure increase and volume flow rate of the cooling liquid from the dry cooler unit 210 throughout the liquid distribution circuit 208. It is further contemplated that instead of a dry cooler unit 210, the cooling facility may instead include a cooling tower and/or a chiller.

The liquid cooling arrangement 200 further includes a plurality of heat exchangers (HEXs) 212-214. In the illustrated embodiment, the HEXs 212-214 are fluidly connected in parallel via the liquid distribution circuit 208. It will be appreciated, however, that the HEXs 110-114 may be fluidly interconnected in other configurations, such as, for example, in series via the liquid distribution circuit 208 without departing from the concepts of the disclosed technology. Additionally, it is contemplated that the HEXs 212-214 be implemented in parallel to the plurality of server clusters 201, in series with the plurality of server clusters 201 (i.e. either before or after the plurality of server clusters 201), between the plurality of server clusters 201 (ex. between the first server cluster 202 and the second server cluster 204), or parallel to one or more of the first server cluster 202, the second server cluster 204 and the third server cluster 206. In some embodiments, the HEX may be implemented as an air-to-liquid heat exchanger (ALHEX), a copper heat exchanger, or a plate heat exchanger.

The HEXs 212-214 function to sufficiently cool the ambient air surrounding the first server cluster 202, the second server cluster 204 and the third server cluster 206. The HEXs 212-214 may embody any suitable configuration that reduces liquid temperatures through supplied air flow (e.g. by compact fans), such as, internal cooling coils, heat extracting air flow fins, *etc.* The HEXs 212-214 may be, for example, disposed on rear doors of the rack hosting the plurality of server clusters 201, to directly cool the air exiting the plurality of server clusters 201, warmed by the air-cooled components therein.

As noted above, certain servers containing high-performance electronic processing components experience higher-generating temperature profiles than other servers. Also, as a general rule, liquid cooled components arranged in parallel decrease the fluid pressure drop experienced by the liquid distribution circuit 105, thereby allowing the pump 216 to operate efficiently in providing adequate flow rates circulating throughout the liquid distribution circuit 105.

In view of these operational factors, the liquid cooling arrangement 200 provides a configuration in which one or more server clusters incorporating high-performance electronic processing components are designated to be "high priority" server clusters while server clusters not incorporating high-performance electronic processing components are designated to be "standard priority" server clusters.

That is, as shown in FIG. 2, the liquid cooling arrangement 200 configures the one or more high priority server clusters to be arranged in parallel manner and in fluid connection with the HEXs 212-214 via the liquid distribution circuit 208. The configuration also positions the one or more high priority server clusters in close proximity to the HEXs 212-214. In this configuration, the one or more high priority server clusters (such as the first server cluster 202) are situated to first receive the "coldest" cooling liquid provided by the liquid distribution circuit 208 to specifically address the particular cooling needs of the high priority server clusters (such as the first server cluster 202).

After the "coldest" cooling liquid is internally circulated through each of the data processing assemblies "high priority" server clusters, the liquid egressing out is then supplied to the "standard priority" server clusters for cooling therein via the liquid distribution circuit 208.

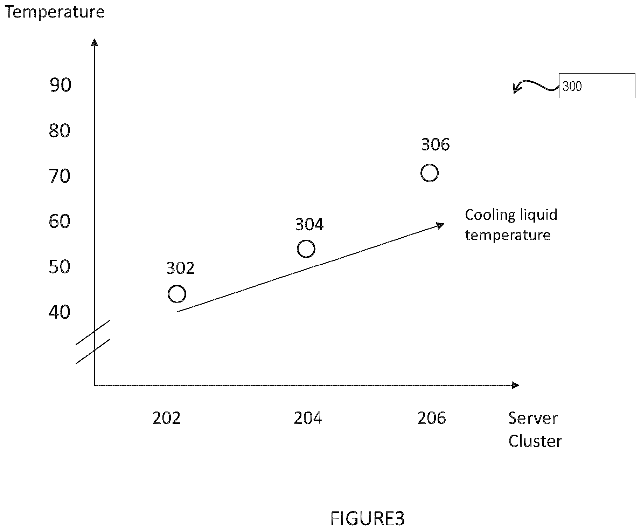

Referring to Figure 3, there is depicted a schematic graph 300 illustrating the operational upper casing temperatures of the plurality of server clusters 201 and the gradual change in the temperature of the cooling liquid. Let us assume that the first server cluster 202 corresponds to a "high priority" server cluster as described above, and each of the second server cluster 204 and third server cluster 206 correspond to a "standard priority" server cluster.

In some embodiments, the respective operational upper casing temperatures of the first server cluster 202, the second server cluster 204, and the third server cluster 206 are configured to increase sequentially along the flow path of the cooling liquid. This arrangement ensures that the cooling liquid, which absorbs heat as it flows through each server cluster, remains sufficiently effective to cool downstream clusters. By allowing the downstream clusters to tolerate progressively higher casing temperatures, the present technology minimizes the risk of the cooling liquid becoming overheated and unable to maintain proper thermal management. This configuration optimizes the thermal efficiency of the liquid distribution circuit 208 while ensure operation of all server clusters within their respective thermal limits.

In certain implementations, the electronic processing components of the servers are enclosed inside a casing thermally connected to the water blocks; the high priority server cluster (i.e. the first server cluster 202) may require operational upper casing temperature below approximately 50°C while standard priority server clusters (such as the second server cluster 204 and third server cluster 206) may require operational upper casing temperatures ranging from approximately 50°C to 80°C.

Let us assume, for the purpose of explanation, that the first server cluster 202 has a first operational upper casing temperature 302 of 40°C, the second server cluster 204 has a second operational upper casing temperature 304 of 55°C, and the third server cluster 206 has a third operational upper casing temperature 306 of 70°C.

While the liquid egressing from the high priority server cluster (i.e. the first server cluster 202), via the liquid distribution circuit 208, will typically be warmer than the "coldest" cooling liquid due to the respective heat-generating processing assemblies, the temperature of the "warm" liquid will generally remain at levels that sufficiently cool the subsequent standard priority server cluster (i.e. the second server cluster 204). This is due to the fact that the standard priority server clusters do not employ high-performance electronic processing components having higher-generating temperature profiles that require a lower temperature (*i.e.,* "coldest") cooling liquid. In certain implementations, the coldest liquid temperature may range from approximately 25°C to 35°C while the warm liquid temperature may range from approximately 35°C to 45°C.

After the "warm" liquid has been internally circulated through each of the data processing assemblies and cooling units of the third server cluster 206, the liquid egressing out is heated. The "heated" liquid is forwarded to the return side of the liquid distribution circuit 208 for return back to the cooling facility 207 for recooling and recirculation back to the plurality of server clusters 201. In certain implementations, the heated liquid temperature may range from approximately 45°C to 65°C.

It should be understood that the cooling liquid temperature be below the respective operational temperatures of the respective server clusters when ingressing. In other words, the temperature of the cooling liquid must be below the first operational upper casing temperature 302 when ingressing into the first server cluster 202, and below the second operational upper casing temperature 304 when ingressing into the second server cluster 204, and below the third operational upper casing temperature 306 when ingressing into the third server cluster 206.

Although in the present embodiment, only the combination of one "high priority" server cluster (i.e. first server cluster 202) and two "standard priority" server clusters (second server cluster 204, and third server cluster 206) has been described, it should be understood that it is contemplated that other combination with more or less "high priority"/ "standard priority" server clusters be possible.

Returning to FIG. 2, attention will now be given to the first server cluster 202, the second server cluster 204, and the third server cluster 206, each connected sequentially within the liquid distribution circuit 208. Each of the first server cluster 202, the second server cluster 204, and the third server cluster 206 includes a set of electronic processing components and a corresponding set of liquid cooling units that are connected in parallel within a given server cluster.

The first server cluster 202 comprises a first set of electronic processing components 202b1-202b5 and a first set of liquid cooling units 202a1-202a5. Each liquid cooling unit (e.g. 202a1) is in direct thermal contact with a corresponding electronic processing component (e.g. 202b1). The first set of liquid cooling units 202a1-202a5 receives the cooling liquid from the distribution loop 208 and egress the cooled liquid back into the distribution loop 208. Although five liquid cooling units are illustrated in the first server cluster 202, it is not limited as such. It is contemplated that the first server cluster 202 includes N numbers of cooling units.

The second server cluster 204 comprises a second set of electronic processing components 204b1-204b4 and a second set of liquid cooling units 204a1-204a4. Each liquid cooling unit (e.g. 204a1) is in direct thermal contact with a corresponding electronic processing component (e.g. 204b1). The second set of liquid cooling units 204a1-204a4 receive the cooling liquid egressed from the first server cluster 202 from the liquid distribution circuit 208, and egress the cooling liquid back into the liquid distribution circuit 208. Although four liquid cooling units are illustrated in the second server cluster 204, it is not limited as such. It is contemplated that the second server cluster 204 includes M numbers of cooling units.

The third server cluster 206 comprises a third set of electronic processing components 206b1-206b3 and a third set of liquid cooling units 206a1-206a3. Each liquid cooling unit (e.g. 206a1) is in direct thermal contact with a corresponding electronic processing component (e.g. 206b1). The third set of liquid cooling units 206a1-206a3 receives the cooling liquid egressed from the second server cluster 204 from the liquid distribution circuit 208 and egress the cooled liquid back into the liquid distribution circuit 208. Although three liquid cooling units are illustrated in the third server cluster 206, it is not limited as such. It is contemplated that the third server cluster 206 includes P numbers of cooling units.

As noted above, the number of liquid cooling units included in each of the first server cluster 202 (N), the second server cluster 204 (M), and the third server cluster 206 (P) is different, where M > N > P. In other words, as the liquid distribution circuit 208 circulates the cooling liquid through the plurality of server clusters 201, each subsequent downstream server clusters comprises less liquid cooling units than its upstream server cluster. In some non-limiting embodiments, it is contemplated to have a configuration where the numbers of liquid cooling units are not decreasing at each subsequent server clusters, depending on the type of electronic processing components included in the server cluster. For example, it is contemplated that a configuration be implemented where M<N<P, or M>N<P.

In some non-limiting embodiments of the present technology, it is also contemplated that the type of liquid cooling units included in the first server cluster 202, the second server cluster 204, and the third server cluster 206 be different from one another. In other words, it is contemplated that the interfacing portions of the respective first set of liquid cooling units 202a1-202a5, the second set of liquid cooling units 204a1-204a4, the third set of liquid cooling units 206a1-206a3 have different geometry for circulating the cooling liquid. This variation allows the liquid cooling arrangement to adapt to differing cooling requirements at each cluster. Needless to say, it is also contemplated that a given set of liquid cooling units (such as the first set of liquid cooling units 202a1-202a5) be comprised of liquid cooling units having interfacing portions with different geometry.

As shown, each of the data processing assemblies (such as the data processing assembly 100) incorporates at least one respective liquid cooling block unit (such as the block unit 102) disposed in direct thermal contact with the heat-generating electronic processing components. The block unit 102 is configured with internal conduits (*not shown*) to accommodate the circulated flow of channelized cooling liquid therethrough. The channelized cooling liquid is provided by a cooling liquid supply that is serially conveyed to each of the liquid cooling block units via an internal server cluster liquid circulating channel 30 to absorb the thermal energy from the heat-generating electronic components and discharge the heated liquid therefrom.

By decreasing the number of liquid cooling units, the present technology allows an increase in both flow rate and pressure difference (ΔP) of the cooling liquid of the liquid cooling units at each subsequent server clusters as the same volume of cooling liquid must pass through fewer liquid cooling units.

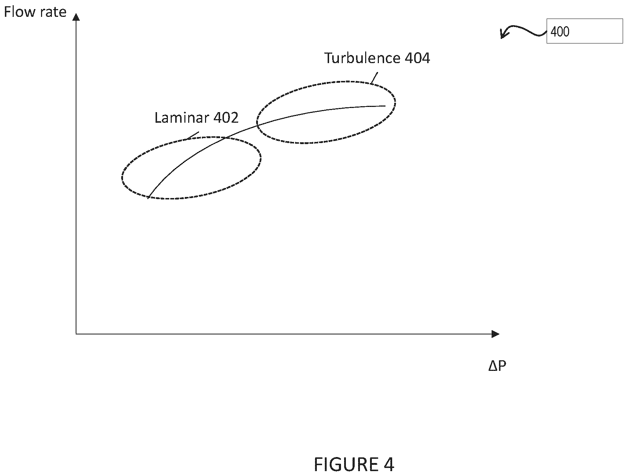

Referring to Figure 4, there is depicted a schematic graph 400 illustrating the flow rate and ΔP of the cooling liquid of the liquid distribution circuit 208.

The pump 216 is configured to control a flow rate of the cooling liquid ingressing the first server cluster 202. The flow rate of the cooling liquid increases progressively downstream, such that the flow rate of the cooling liquid entering the first set of liquid cooling units 202a1-202a5is lower than the flow rate of the cooling liquid entering the second set of liquid cooling units 204a1-204a4, which is also lower than the flow rate of the cooling liquid entering the third set of liquid cooling units 206a1-206a3.

In some non-limiting embodiments, the flow regime of the cooling liquid may vary between the first set of liquid cooling units 202a1-202a5, the second set of liquid cooling units 204a1-204a4 and the third set of liquid cooling units 206a1-206a3. For example, the cooling liquid may circulate in a laminar flow regime 402 only in the first set of liquid cooling units 202a1-202a5and in a turbulence flow regime 404 within the second set of liquid cooling units 204a1-204a4 and the third set of liquid cooling units 206a1-206a3. In other non-limiting embodiments, it is contemplated that the cooling liquid circulate in the turbulence flow regime 404 in the first set of liquid cooling units 202a1-202a5, the second set of liquid cooling units 204a1-204a4 and the third set of liquid cooling units 206a1-206a3.

The transition from the laminar flow regime 402 to the turbulence flow regime 404 in the liquid cooling arrangement 200 is influenced by the physical properties of the cooling liquid, which changes as the cooling liquid absorbs heat from the electronic processing components (as described above). As the cooling liquid becomes warmer downstream, its viscosity decreases, reducing the resistance to flow, thereby increasing the Reynolds number (Re), a key factor in determining flow regime. Additionally, the reduced number of liquid cooling units in the downstream server clusters results in higher flow velocity and ΔP, further contributing to the rise in *Re.* This interplay of increased velocity and decreased viscosity drives the cooling liquid towards turbulence in the liquid cooling liquid units placed in the downstream server clusters (i.e. the second set of liquid cooling units 204a1-204a4 and the third set of liquid cooling units 206a1-206a3) of the liquid distribution circuit 208.

An advantage of the cooling liquid circulating in the turbulence flow regime 404 is the improved heat capture by the cooling liquid. Indeed, in the turbulence flow regime 404, the irregular motion minimizes the thermal boundary layer near the heating surfaces, thereby allowing the cooling liquid to come into contact with the heated surface more frequently, thereby enhancing the rate of heat transfer compared to laminar flow. As such, the present technology allows variation of the cooling liquid flow rate to selectively be in one of laminar flow regime or turbulence flow regime at liquid cooling liquid units, without the need of additional pump(s) to be installed between server clusters.

Although in the illustrated embodiment, the cooling liquid exhibits a laminar flow regime 402 only in the first set of liquid cooling units 202a1-202a5, and a turbulence flow regime 404 in the second set of liquid cooling units 204a1-204a4 and the third set of liquid cooling units 206a1-206a3, it is not limited as such. For example, the cooling liquid may only achieve a turbulence flow regime 404 in the third set of liquid cooling units 206a1-206a3.

In this manner, the liquid cooling arrangement 200 provides configurations that optimize the overall cooling efficiency by separately addressing the liquid cooling needs of high priority server clusters and standard priority server clusters.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A liquid cooling system (200) for cooling a plurality of server clusters (202, 204, 206) that each contain heat generating devices (202b1-202b5, 204b1-204b4, 206b1-206b3) with liquid cooling units (202a1-202a5, 204a1-204a4, 206a1-202a3), comprising:
a cooling circuit 208 configured to circulate a cooling liquid to the plurality of server clusters (202, 204, 206) and to circulate a heated liquid from the plurality of server clusters (202, 204, 206) back to a dry cooler unit (210);
the plurality of server clusters (202, 204, 206) including:
a first cluster (202) and a second cluster (204) connected in series by the cooling circuit (208),
the first cluster (202) including a first set of liquid cooling units (202a1-202a5) connected in parallel by the cooling circuit, the first set having a first number of liquid cooling units (202a1-202a5),
the second cluster (204) including a second set of liquid cooling units (204a1-204a5) connected in parallel by the cooling circuit, the second set having a second number of liquid cooling units (204a1-204a5), the second cluster positioned further downstream along the cooling circuit (208) and configured to receive the cooling liquid egressing out of the first cluster (202), wherein
the first number being above the second number.

2. The liquid cooling system of claim 1, wherein the first cluster (202) further includes a first set of heat-generating components (202b1-202b5), the first set of heat-generating components (202b1-202b5) having the first number of heat-generating components (202b1-202b5), and the second cluster (204) further includes a second set of heat generating components (204b1-204b5), the second set of heat-generating components (204b1-204b5) having the second number of heat-generating components (204b1-204b5).

3. The liquid cooling system of claim 2, wherein at least one of the first set of heat-generating components (202b1-202b5) is configured to operate below a first operational upper casing temperature (302), the at least one of the second set of heat-generating components(204b 1-204b5) is configured to below a second operational upper casing temperature (304),
the first operational upper casing temperature (302) being below the second operational upper casing temperature (304).

4. The liquid cooling system of claim 3, wherein the cooling liquid entering into the first cluster (202) is below the first operational upper casing temperature (302), and the cooling liquid egressing out of the first cluster (202) is below the second operational upper casing temperature (304).

5. The liquid cooling system of any one of claims 1 to 4, wherein the cooling circuit (208) is configured to circulate the cooling liquid in the first set of liquid cooling units (202a1-202a5) (204) at a first flow rate (402) and in the second set of liquid cooling units (204a1-204a5)at a second flow rate (404),
the first flow rate (402) being below the second flow rate (404).

6. The liquid cooling system of claim 5, wherein the cooling liquid is circulating with one of a laminar flow regime or a turbulence flow regime at the first flow rate (402), and with a turbulence flow regime at the second flow rate (404).

7. The liquid cooling system of any one of claims 1 to 6, wherein the cooling circuit (208) has a first interfacing portion with the first set of heat-generating components and a second interfacing portion with the second set of heat-generating components, a first geometry of the first interfacing portion being different from a second geometry of the second interfacing portion.

8. The liquid cooling system of claim 1 further comprising one or more heat exchangers (212, 214) fluidly connected to the cooling circuit (208), wherein the one or more heat exchangers (212-214) comprises one of air-to-liquid heat exchangers, copper heat exchangers, or plate heat exchangers.

9. The liquid cooling system of claim 1, wherein the dry cooler unit (210) is configured to cool received heated cooling liquid from the plurality of server clusters (202, 204, 206).

10. The liquid cooling system of claim 1, further comprising a pump (216) configured to control a flow of the cooling liquid entering the first cluster (202).

11. The liquid cooling system of claim 1, wherein the plurality of server clusters (202, 204, 206) further comprises a third cluster (206) connected in series to the first cluster (202) and the second cluster (204) by the cooling circuit (208), the third cluster (206) comprising a third set of liquid cooling units (206a1-206a3) connected in parallel by the cooling circuit, the third set (206a1-206a3) having a third number of liquid cooling units, the third cluster positioned further downstream along the cooling circuit and configured to receive the cooling liquid egressing out of the second cluster (204), wherein the second number being above the third number.

12. The liquid cooling system of claim 6, wherein the third cluster further includes a third set of heat-generating components (206b1-206b3) configured to operate below a at a third operational upper casing temperature (306), the second operational upper casing temperature (304) being below the third operational upper casing temperature (306), and wherein the cooling liquid egressing out of the second cluster (204) is below the third operational upper casing temperature (306).

13. The liquid cooling system of claim 1, wherein the plurality of server clusters is installed on a server rack assembly.

14. The liquid cooling system of claim 1, wherein the plurality of server clusters is installed across a plurality of server rack assemblies.

15. A liquid cooling system (200) for cooling a plurality of server clusters (202, 204, 206) that each contain heat generating devices (202b1-202b5, 204b1-204b4, 206b1-206b3) with liquid cooling units (202a1-202a5, 204a1-204a4, 206a1-202a3), comprising:
a cooling circuit 208 configured to circulate a cooling liquid to the plurality of server clusters (202, 204, 206) and to circulate a heated liquid from the plurality of server clusters (202, 204, 206) back to a dry cooler unit (210);
one or more heat exchangers (212, 214) fluidly connected to the cooling circuit (208),
the plurality of server clusters (202, 204, 206) including:
a first cluster (202) and a second cluster (204) connected in series by the cooling circuit (208),
the first cluster (202) including a first set of liquid cooling units (202a1-202a5) connected in parallel by the cooling circuit, the first set having a first number of liquid cooling units (202a1-202a5),
the second cluster (204) including a second set of liquid cooling units (204a1-204a5) connected in parallel by the cooling circuit, the second set having a second number of liquid cooling units (204a1-204a5), the second cluster positioned further downstream along the cooling circuit (208) and configured to receive the cooling liquid egressing out of the first cluster (202), wherein
the first number being below the second number.

## Amended claims

### Amended claims in accordance with Rule 137(2) EPC.

1. A liquid cooling system (200) for cooling a plurality of server clusters (202, 204, 206) that each contain heat generating devices (202b1-202b5, 204b1-204b4, 206b1-206b3) with liquid cooling units (202a1-202a5, 204a1-204a4, 206a1-202a3), comprising:
a cooling circuit 208 configured to circulate a cooling liquid to the plurality of server clusters (202, 204, 206) and to circulate a heated liquid from the plurality of server clusters (202, 204, 206) back to a dry cooler unit (210);
the plurality of server clusters (202, 204, 206) including:
a first cluster (202) and a second cluster (204) connected in series by the cooling circuit (208),
the first cluster (202) including a first set of liquid cooling units (202a1-202a5) connected in parallel by the cooling circuit, the first set having a first number of liquid cooling units (202a1-202a5),
the second cluster (204) including a second set of liquid cooling units (204a1-204a5) connected in parallel by the cooling circuit, the second set having a second number of liquid cooling units (204a1-204a5), the second cluster positioned further downstream along the cooling circuit (208) and configured to receive the cooling liquid egressing out of the first cluster (202), wherein
the first number being above the second number.

2. The liquid cooling system of claim 1, wherein the first cluster (202) further includes a first set of heat-generating components (202b1-202b5), the first set of heat-generating components (202b1-202b5) having the first number of heat-generating components (202b1-202b5), and the second cluster (204) further includes a second set of heat generating components (204b1-204b5), the second set of heat-generating components (204b1-204b5) having the second number of heat-generating components (204b 1-204b5).

3. The liquid cooling system of claim 2, wherein at least one of the first set of heat-generating components (202b1-202b5) is configured to operate below a first operational upper casing temperature (302), the at least one of the second set of heat-generating components(204b1-204b5) is configured to below a second operational upper casing temperature (304),
the first operational upper casing temperature (302) being below the second operational upper casing temperature (304).

4. The liquid cooling system of any one of claims 1 to 3, wherein the cooling circuit (208) is configured to circulate the cooling liquid in the first set of liquid cooling units (202a1-202a5) (204) at a first flow rate (402) and in the second set of liquid cooling units (204a1-204a5)at a second flow rate (404),
the first flow rate (402) being below the second flow rate (404).

5. The liquid cooling system of any one of claims 1 to 4, wherein the cooling circuit (208) has a first interfacing portion with the first set of heat-generating components and a second interfacing portion with the second set of heat-generating components, a first geometry of the first interfacing portion being different from a second geometry of the second interfacing portion.

6. The liquid cooling system of claim 1 further comprising one or more heat exchangers (212, 214) fluidly connected to the cooling circuit (208), wherein the one or more heat exchangers (212-214) comprises one of air-to-liquid heat exchangers, copper heat exchangers, or plate heat exchangers.

7. The liquid cooling system of claim 1, wherein the dry cooler unit (210) is configured to cool received heated cooling liquid from the plurality of server clusters (202, 204, 206).

8. The liquid cooling system of claim 1, further comprising a pump (216) configured to control a flow of the cooling liquid entering the first cluster (202).

9. The liquid cooling system of claim 1, wherein the plurality of server clusters (202, 204, 206) further comprises a third cluster (206) connected in series to the first cluster (202) and the second cluster (204) by the cooling circuit (208), the third cluster (206) comprising a third set of liquid cooling units (206a1-206a3) connected in parallel by the cooling circuit, the third set (206a1-206a3) having a third number of liquid cooling units, the third cluster positioned further downstream along the cooling circuit and configured to receive the cooling liquid egressing out of the second cluster (204), wherein the second number being above the third number.

10. The liquid cooling system of claim 1, wherein the plurality of server clusters is installed on a server rack assembly.

11. The liquid cooling system of claim 1, wherein the plurality of server clusters is installed across a plurality of server rack assemblies.
